# FASCICULE DE BREVET EUROPEEN

(11) **EP 3 716 345 B1**
(45) Date de publication et mention de la délivrance du brevet: **31.03.2021**
(21) Numéro de dépôt: 20165915.8
(22) Date de dépôt: 26.03.2020
(51) Int. Cl.: H01L 31/107, H01L 31/18, H01L 31/0216

(54) **PROCÉDÉ DE FABRICATION D'UNE PUCE PHOTONIQUE COMPRENANT UNE PHOTODIODE SACM-APD COUPLÉE OPTIQUEMENT À UN GUIDE D'ONDES INTÉGRÉ**
HERSTELLUNGSVERFAHREN EINES PHOTONENCHIPS, DER EINE AVALANCHE-FOTODIODE MIT SACM-STRUKTUR UMFASST, DIE OPTISCH AN EINEN INTEGRIERTEN WELLENLEITER GEKOPPELT IST
METHOD FOR MANUFACTURING A PHOTONIC CHIP COMPRISING AN SACM-APD PHOTODIODE OPTICALLY COUPLED WITH AN INTEGRATED WAVEGUIDE

(30) Priorité: 29.03.2019 FR 1903401
(43) Date de publication de la demande: 30.09.2020
(73) Titulaire: Commissariat à l'énergie atomique et aux énergies alternatives, 75015 Paris (FR)
(72) Inventeur: SZELAG, Bertrand, 38054 GRENOBLE Cedex 09 (FR); ADELMINI, Laetitia, 38054 GRENOBLE Cedex 09 (FR); BRISION, Stéphane, 38054 GRENOBLE Cedex 09 (FR)
(74) Mandataire: INNOV-GROUP

(56) Documents cités:
- JP-A- 2017 147 352
- US-A1- 2014 291 682
- US-A1- 2019 019 903
- ZHIHONG HUANG ET AL: "25 Gbps low-voltage waveguide Si-Ge avalanche photodiode", OPTICA, vol. 3, no. 8, 21 juillet 2016 (2016-07-21), pages 793-797, XP055649294, DOI: 10.1364/OPTICA.3.000793
- HUI CONG ET AL: "High-speed waveguide-integrated Ge/Si avalanche photodetector", CHINESE PHYSICS B, vol. 25, no. 5, 6 mai 2016 (2016-05-06), page 58503, XP020302456, ISSN: 1674-1056, DOI: 10.1088/1674-1056/25/5/058503 [extrait le 2016-05-06]
- XIAOXIN WANG ET AL: "80 GHz bandwidth-gain-product Ge/Si avalanche photodetector by selective Ge growth", 2009 CONFERENCE ON OPTICAL FIBER COMMUNICATION, 22 mars 2009 (2009-03-22), - 26 mars 2009 (2009-03-26), pages 1-3, XP031467713, ISBN: 978-1-4244-2606-5

## Description

### DOMAINE TECHNIQUE

Le domaine de l'invention est celui des procédés de fabrication des puces photoniques comportant au moins une photodiode SACM-APD, c'est-à-dire une photodiode à avalanche de type SACM (pour *Separated Absorption Charge Multiplication,* en anglais) couplée optiquement à un guide d'onde intégré dans un substrat de la puce photonique. L'invention peut en particulier être mise en oeuvre dans le cadre de la technologie dite de photonique intégrée sur silicium.

### ÉTAT DE LA TECHNIQUE ANTÉRIEURE

La photonique intégrée est une technologie qui consiste à fabriquer une puce photonique comportant un circuit photonique formé d'au moins un guide d'onde couplé optiquement à au moins un composant optique actif tel qu'une source lumineuse, un photodétecteur, ou un modulateur optique, entre autres. Elle est dite intégrée dans le sens où le circuit photonique et les composants optiques actifs sont réalisés à partir d'un même substrat support. Lorsque le substrat support est un substrat SOI (pour *Silicon On Insulator*, en anglais), on parle alors de photonique sur silicium. Les guides d'onde sont alors réalisés en un cœur de silicium entouré d'une gaine en un oxyde de silicium. Les photodiodes, par exemple des photodiodes à avalanche, peuvent être réalisées à base de germanium du fait du fort coefficient d'absorption de ce matériau. De telles puces photoniques peuvent notamment être utilisées dans le cadre des communications datacom ou télécom, dans la mesure où le silicium est transparent aux longueurs d'onde du télécom optique, c'est-à-dire à 1,3µm et 1,55µm.

Les photodiodes de telles puces photoniques peuvent être formées chacune d'un empilement, suivant un axe orthogonal à un substrat support, d'une portion de contact dopée p, d'une portion de contact dopée n et d'une portion d'absorption située entre les deux portions de contact. Il s'agit alors d'une configuration mésa, qui diffère de la configuration plane dans laquelle les différentes portions se succèdent suivant un axe parallèle au substrat support.

Une photodiode en configuration mésa peut être soit illuminée par la surface, soit couplée optiquement à un guide d'onde intégré dans la puce photonique. Dans le premier cas, le rayonnement lumineux peut être transmis par exemple par une fibre optique, laquelle peut alors être assemblée à la puce photonique suivant un axe orthogonal ou incliné vis-à-vis du substrat support. Dans le deuxième cas, le rayonnement lumineux circule dans le guide d'onde intégré à la puce photonique, lequel s'étend alors dans un plan parallèle au substrat support. Le guide d'onde peut être couplé optiquement à la portion d'absorption de manière évanescente lorsqu'il s'étend dans un plan distinct de celui de la portion d'absorption. En revanche, lorsqu'il s'étend de manière coplanaire à celui de la portion d'absorption, le couplage optique est alors direct.

Les photodiodes peuvent être des photodiodes à avalanche (APD pour *Avalanche Photodiode*, en anglais) de type SACM (pour *Separated Absorption Charge Multiplication*, en anglais). Ces photodiodes comportent une zone mince dopée dite de charge, située sur la portion de multiplication à l'interface avec la portion d'absorption. De telles photodiodes sont généralement notées SACM-APD. Rappelons qu'une photodiode APD est une photodiode dont la polarisation inverse élevée provoque une multiplication des porteurs de charge présents dans la zone de déplétion grâce au phénomène d'ionisation par impact. La présence de la zone de charge permet d'éviter que la zone de charge d'espace ne s'étende dans la portion d'absorption du fait de la polarisation inverse élevée, et donc que les deux types de porteurs photogénérés ne soient présents dans la portion de multiplication. La zone de charge permet donc de contrôler l'uniformité du champ électrique dans la portion de multiplication. Dans le cas de photodiodes en germanium sur silicium, la portion d'absorption est réalisée en germanium, et la zone de charge et la portion de multiplication sont réalisées en silicium. La zone de charge permet alors d'optimiser la multiplication dans le Si et l'extraction des porteurs photogénérés dans le Ge.

Cependant, il apparaît que les photodiodes en configuration mésa peuvent présenter des risques de claquage en bordure de photodiode, du fait d'une plus forte valeur du taux de génération de porteurs de charge en bordure de la photodiode qu'au centre. Pour réduire les risques de claquage, et plus généralement pour améliorer les performances de la photodiode, il est connu de réaliser la portion de multiplication, la zone de charge et la portion d'absorption de sorte qu'elles présentent chacune un retrait périphérique vis-à-vis de la portion ou zone sous-jacente. Ainsi, la zone de charge présente un retrait périphérique d'une valeur non nulle dr_{zc} vis-à-vis de la bordure de la portion de multiplication, et la portion d'absorption présente un retrait périphérique d'une valeur non nulle drₚₐ vis-à-vis de la bordure de la zone de charge.

Ainsi, l'article de Huang et al intitulé 25 Gbps low-voltage waveguide Si-Ge avalanche photodiode, Optica, Vol. 3, No. 8, 793 (2016) décrit un procédé de fabrication d'une photodiode SACM-APD en germanium sur silicium en configuration mésa, couplée optiquement à un guide d'onde intégré. Ici, la portion d'absorption est dimensionnée de sorte qu'elle présente un retrait périphérique vis-à-vis de la zone de charge sous-jacente. Pour cela, le procédé de fabrication comporte une étape de croissance épitaxiale sélective de la portion d'absorption en germanium dans une cavité débouchant sur la zone de charge en silicium dopé p-, cette cavité étant définie par photolithographie. Il en résulte donc un risque de défaut de positionnement de la portion d'absorption vis-à-vis de la zone de charge, ce défaut de positionnement étant susceptibles de dégrader les propriétés optiques et/ou électroniques de la photodiode.

Par ailleurs, l'article de Dong et al intitulé Germanium-tin multiple quantum well on silicon avalanche photodiode for photodetection at two micron wavelength Semicond. Sci. Technol. 31, 095001 (2016) décrit un procédé de fabrication d'une photodiode SACM-APD en germanium sur silicium en configuration mésa et illuminée par la surface. Ici, la portion d'absorption, la zone de charge d'espace et la portion de multiplication présentent des retraits périphériques successifs, obtenus lors d'une étape de formation de la configuration en mésa au moyen d'une gravure chimique en solution aqueuse (NH₄)₂S. Les dimensions des retraits périphériques dépendent notamment des conditions opératoires de la gravure chimique et des propriétés de l'agent de gravure et des matériaux à graver, et ne peuvent donc pas être contrôlées précisément. De plus, dans la mesure où il n'y a pas de détection de fin de gravure, la photodiode ne peut être couplée optiquement à un guide d'onde intégré, dans la mesure où celui-ci est susceptible d'être gravé partiellement lors de la gravure chimique mise en œuvre.

Les documents US2014/291682A1, US2019019903A1 et JP2017147352A, l'article de Cong et al intitulé High-speed waveguide-integrated Ge/Si avalanche photodetector, Chinese Physics B, Vol.25, n°5, 58503 (2016), et l'article de Wang et al intitulé 80GHz bandwidth-gain-product Ge/Si avalanche photodetector by selective Ge growth, 2009 Conference on Optical Fiber Communication, 22-26 mars 2009, décrivent différents exemples de photodiodes APD-SACM.

### EXPOSÉ DE L'INVENTION

L'invention a pour objectif de remédier au moins en partie aux inconvénients de l'art antérieur, et plus particulièrement de proposer un procédé de fabrication d'une puce photonique comportant une photodiode APD-SACM, en configuration mésa, couplée optiquement à un guide d'onde intégré, dont les propriétés optiques et/ou électroniques de la photodiode sont optimisées.

Pour cela, l'objet de l'invention est un procédé de fabrication d'une puce photonique comportant au moins une photodiode de type SACM-APD reposant sur un substrat support, et un guide d'onde s'étendant de manière parallèle au substrat support et couplé optiquement à la photodiode. Le procédé comporte les étapes suivantes :
o réalisation d'une portion de contact en un premier matériau semiconducteur dopé selon un premier type de conductivité, à partir d'une couche du premier matériau semiconducteur reposant sur une couche isolante du substrat support ;
o dépôt d'une couche d'encapsulation recouvrant la portion de contact, et réalisation d'une ouverture traversante au travers de la couche d'encapsulation débouchant sur une surface de la portion de contact ;
o réalisation, dans l'ouverture traversante, d'une portion de multiplication en le premier matériau semiconducteur à partir de la surface de la portion de contact, la portion de multiplication présentant une épaisseur inférieure à une hauteur de l'ouverture traversante ;
o réalisation d'un premier espaceur en un premier matériau diélectrique, de sorte qu'il recouvre les flancs de l'ouverture traversante ainsi qu'une partie périphérique de largeur constante d'une surface de la portion de multiplication ;
o réalisation d'une zone de charge dans la portion de multiplication et affleurant une face supérieure de celle-ci, la zone de charge étant délimitée latéralement par le premier espaceur de sorte qu'elle présente un retrait périphérique constant dr_{zc} vis-à-vis d'une bordure de la portion de multiplication ;
o réalisation d'un deuxième espaceur en un deuxième matériau diélectrique, distinct du premier matériau diélectrique, de sorte qu'il recouvre le premier espaceur ainsi qu'une partie périphérique de largeur constante d'une surface de la zone de charge ;
o réalisation d'une portion d'absorption en un deuxième matériau semiconducteur, à partir d'une surface libre de la zone de charge, la portion d'absorption étant délimitée latéralement, à l'interface avec la zone de charge, par le deuxième espaceur de sorte qu'elle présente un retrait périphérique constant drₚₐ vis-à-vis d'une bordure de la zone de charge.

Certains aspects préférés mais non limitatifs de ce procédé de fabrication sont les suivants.

Le premier matériau diélectrique peut être adapté à être gravé sélectivement vis-à-vis du matériau de la couche d'encapsulation et du premier matériau semiconducteur, et le deuxième matériau diélectrique peut être adapté à être gravé sélectivement vis-à-vis du premier matériau diélectrique.

L'étape de réalisation du premier espaceur peut comporter :
∘ un dépôt conforme d'une première couche d'espacement en le premier matériau diélectrique, de manière à recouvrir une face supérieure de la couche d'encapsulation, les flancs de l'ouverture traversante, et la surface de la portion de multiplication, l'épaisseur de la première couche d'espacement définissant ultérieurement la valeur dr_{zc} du retrait périphérique de la zone de charge vis-à-vis de la portion de multiplication ;
∘ une gravure anisotrope de la première couche d'espacement, de manière à rendre libre la face supérieure de la couche d'encapsulation ainsi qu'une partie centrale d'une surface de la portion de multiplication, et à ne conserver qu'une partie périphérique formant ledit premier espaceur.

L'étape de réalisation du deuxième espaceur peut comporter :
∘ un dépôt conforme d'une couche mince de protection en le premier matériau diélectrique, de manière à recouvrir la couche d'encapsulation, le premier espaceur, et la zone de charge ;
∘ un dépôt conforme d'une deuxième couche d'espacement en le deuxième matériau diélectrique, de manière à recouvrir la couche mince de protection, l'épaisseur de la deuxième couche d'espacement définissant ultérieurement la valeur drₚₐ du retrait périphérique de la portion d'absorption vis-à-vis de la zone de charge ;
∘ une gravure anisotrope de la deuxième couche d'espacement, de manière à rendre libre une surface de la couche mince de protection située sur la face supérieure de la couche d'encapsulation ainsi qu'une partie centrale située sur la zone de charge, et à ne conserver qu'une partie périphérique formant ledit deuxième espaceur ;
∘ une gravure anisotrope de la couche mince de protection, de manière à rendre libre la face supérieure de la première couche d'encapsulation ainsi qu'une partie centrale d'une surface de la zone de charge.

La zone de charge peut être réalisée entre le dépôt conforme de la couche mince de protection et le dépôt conforme de la deuxième couche d'espacement, par implantation ionique de dopants dans la portion de multiplication au travers de la couche mince de protection.

L'étape de réalisation de la portion de multiplication peut comporter une épitaxie du deuxième matériau semiconducteur de sorte que le matériau épitaxié déborde hors de l'ouverture traversante, suivie d'une étape de planarisation mécano-chimique du matériau épitaxié puis d'une gravure partielle du matériau épitaxié, de manière à former la portion de multiplication.

Le guide d'onde peut être réalisé à partir de la couche du premier matériau semiconducteur, et s'étendre de manière coplanaire et d'un seul tenant avec la portion de contact.

Le procédé de fabrication peut comporter les étapes suivantes :
∘ dépôt d'une couche d'encapsulation supplémentaire recouvrant la portion d'absorption ;
∘ réalisation de vias conducteurs et de plots électriques, les plots électriques reposant sur les couches d'encapsulations, et les vias conducteurs reliant la portion de contact et la portion d'absorption aux plots électriques.

L'invention porte également sur une puce photonique comportant au moins une photodiode de type SACM-APD reposant sur un substrat support et un guide d'onde s'étendant de manière parallèle au substrat support et couplé optiquement à la photodiode, la photodiode comportant un empilement formé de :
∘ une portion de contact en un premier matériau semiconducteur dopé selon un premier type de conductivité, reposant sur une couche isolante du substrat support ;
∘ une couche d'encapsulation, recouvrant la portion de contact et présentant une ouverture traversante débouchant sur la portion de contact ;
∘ une portion de multiplication, reposant sur et au contact de la portion de contact, et située dans l'ouverture traversante ;
∘ une zone de charge, située dans la portion de multiplication et affleurant une face supérieure de celle-ci, et délimitée latéralement par un premier espaceur en un premier matériau diélectrique s'étendant au contact des flancs de l'ouverture traversante de sorte que la zone de charge présente un retrait périphérique constant dr_{zc} vis-à-vis d'une bordure de la portion de multiplication ;
∘ une portion d'absorption, reposant sur et au contact de la zone de charge, et située dans l'ouverture traversante, et délimitée latéralement, à l'interface avec la zone de charge, par un deuxième espaceur en un deuxième matériau diélectrique distinct du premier matériau diélectrique et s'étendant entre et au contact du premier espaceur et de la portion d'absorption, de sorte que la portion d'absorption présente un retrait périphérique constant drₚₐ vis-à-vis d'une bordure de la zone de charge.

La portion d'absorption peut être réalisée à base de germanium, et la portion de multiplication et la portion de contact peuvent être réalisées en silicium.

Le premier espaceur peut être réalisé en un nitrure de silicium, et le deuxième espaceur peut être réalisé en un oxyde de silicium.

Le guide d'onde peut être coplanaire et réalisé d'un seul tenant avec la portion de contact.

Le guide d'onde peut comporter une zone d'élargissement dans laquelle sa largeur augmente en direction de la portion de contact, et la photodiode peut comporter une zone de couplage formée par la portion de multiplication, la zone de charge et la portion d'absorption, et située en regard de la zone d'élargissement, dont la largeur diminue en direction du guide d'onde.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A à 1C sont des vues schématiques et partielles d'une puce photonique obtenue par un procédé de fabrication selon un mode de réalisation, la puce photonique comportant une photodiode APD-SACM en configuration mésa à base de germanium sur silicium, couplée optiquement à un guide d'onde intégré ;
les figures 2A à 2N sont des vues en coupe ou de dessus illustrant différentes étapes d'un procédé de fabrication d'une puce photonique identique ou similaire à celle illustrée sur les fig.1A-1C.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

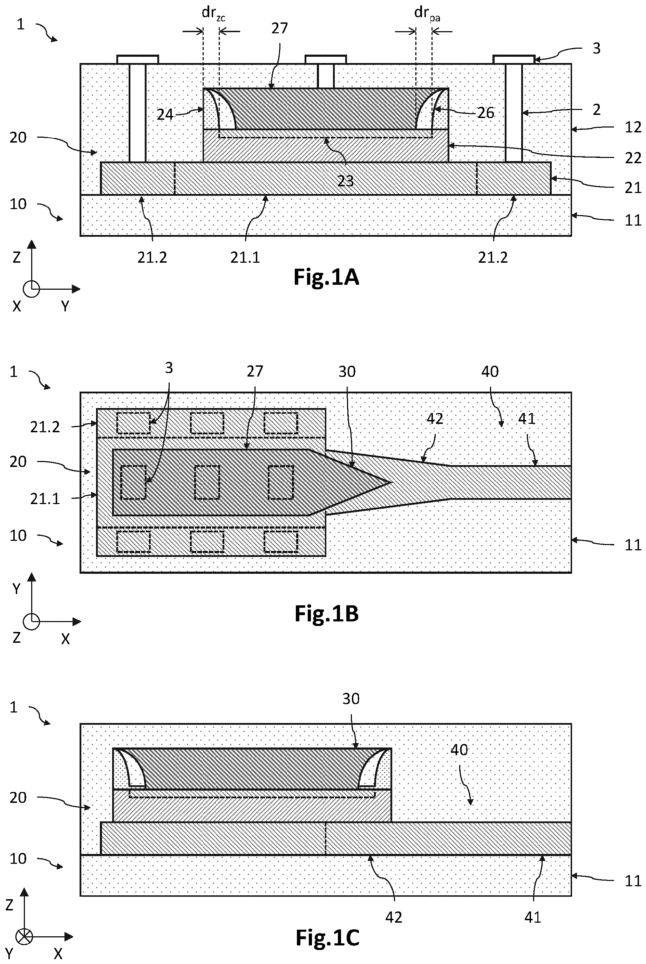

Les figures 1A à 1C sont des vues schématiques et partielles, en coupe et en vue de dessus, d'une puce photonique 1 comportant au moins une photodiode 20 de type APD-SACM couplée optiquement à un guide d'onde intégré 40, cette puce photonique 1 ayant été obtenue par un procédé de fabrication selon un mode de réalisation.

On définit ici et pour la suite de la description un repère direct tridimensionnel orthogonal XYZ, où les axes X et Y forment un plan parallèle au plan principal d'un substrat support 10 de la puce photonique 1, l'axe X étant orienté ici de manière parallèle au guide d'onde 40 au niveau de la zone de couplage avec la photodiode 20, et où l'axe Z est orienté de manière sensiblement orthogonale au plan principal du substrat support 10. Dans la suite de la description, les termes « inférieur » et « supérieur » s'entendent comme étant relatifs à un positionnement croissant lorsqu'on s'éloigne du substrat support 10 suivant la direction +Z.

Dans cet exemple, la photodiode 20 et le guide d'onde 40 sont réalisés dans une technologie de photonique intégrée, c'est-à-dire que la photodiode 20 et le guide d'onde 40 sont réalisés à partir d'un même substrat support 10 de la puce photonique 1. De plus, il s'agit dans cet exemple de photonique sur silicium, et d'une photodiode 20 à base de germanium sur silicium. Autrement dit, le guide d'onde 40, la portion de contact 21 et la portion de multiplication 22 sont réalisés en silicium et la portion d'absorption 27 de la photodiode 20 est réalisée à base de germanium.

La photodiode 20 de type SACM-APD présente une configuration en mésa dans la mesure où elle comporte un empilement semiconducteur orienté suivant l'axe Z orthogonal au plan XY du substrat support 10, cet empilement semiconducteur étant formée de :
- une portion de contact 21, reposant sur une couche isolante 11 du substrat support 10, et réalisée en un premier matériau semiconducteur dopé selon un premier type de conductivité, par exemple ici en silicium dopé n+ ;
- une portion de multiplication 22, reposant sur et au contact de la portion de contact 21, et réalisée en le premier matériau semiconducteur, ici en silicium intrinsèque (non intentionnellement dopé) ;
- une zone de charge 23, située dans la portion de multiplication 22 et affleurant la face supérieure de celle-ci, et réalisée en le premier matériau semiconducteur dopé selon un deuxième type de conductivité, ici en silicium dopé p- ;
- une portion d'absorption 27, reposant sur et au contact de la zone de charge 23, et réalisée à base d'un deuxième matériau semiconducteur, par exemple réalisé en germanium intrinsèque.

Selon l'invention, la portion d'absorption 27 est délimitée latéralement par un premier espaceur 24 réalisé en un premier matériau diélectrique, et par un deuxième espaceur 26 réalisé en un deuxième matériau diélectrique distinct du premier matériau diélectrique. Le premier espaceur 24 permet de délimiter latéralement la zone de charge 23 vis-à-vis de la portion de multiplication 22, et de définir la valeur dr_{zc} du retrait périphérique que forme la zone de charge 23 vis-à-vis de la bordure de la portion de multiplication 22 sous-jacente. Le deuxième espaceur 26 permet de délimiter latéralement la portion d'absorption 27 vis-à-vis de la zone de charge 23, et de définir la valeur drₚₐ du retrait périphérique que forme la portion d'absorption 27 vis-à-vis de la bordure de la zone de charge 23 sous-jacente.

Dans la mesure où le premier espaceur 24 et le deuxième espaceur 26 présentent une dimension transversale (épaisseur dans le plan XY) constante suivant le pourtour de la photodiode 20, les distances dr_{zc} et drₚₐ sont également constantes suivant le pourtour de la photodiode 20. On obtient donc un auto-alignement de la portion d'absorption 27, de la zone de charge 23 et de la portion de multiplication 22, qui contribue à optimiser les propriétés optiques et /ou électroniques de la photodiode 20.

Par ailleurs, comme décrit en détail plus loin, parmi les étapes de réalisation de la portion de multiplication 22, de la zone de charge 23, et de la portion d'absorption 27, seule l'étape de réalisation de la portion de multiplication 22 met en œuvre une opération de photolithographie. On écarte ainsi les risques de désalignement entre la portion d'absorption 27, la zone de charge 23 et la portion de multiplication 22, liés à une mise en œuvre de plusieurs opérations successives de photolithographie. Par ailleurs, on réduit la complexité du procédé de fabrication et on en réduit les coûts, dans la mesure où la mise en œuvre des opérations de photolithographie implique de prendre en compte des tolérances d'alignement relatif entre les portions d'absorption, de multiplication et de charge.

La couche isolante 11 est réalisée en un matériau diélectrique. Il peut s'agir d'une couche d'oxyde d'un substrat support 10 de type SOI (pour *Silicon On Insulator*, en anglais), et d'épaisseur comprise par exemple entre 700nm et 2000nm. Le substrat support 10 peut comporter ou supporter des éléments optiques actifs ou passifs, dont le guide d'onde 40 décrit plus loin. Dans le cadre de la photonique sur silicium, les guides d'onde sont de préférence réalisés en un cœur à base de silicium entouré par une gaine en un oxyde de silicium.

La portion de contact 21 de la photodiode 20 est réalisée à base d'un premier matériau semiconducteur, dopé selon un premier type de conductivité. De préférence, elle est réalisée en silicium dopé n. Elle comporte une zone centrale 21.1 en Si dopé n+ encadrée, dans le plan XY et suivant l'axe Y, par deux zones latérales 21.2 en Si dopé n++. La portion de contact 21 repose sur et au contact de la couche isolante 11. Elle est de préférence formée à partir d'une couche en le premier matériau semiconducteur, par exemple à partir d'une couche de Si dans le cadre d'un substrat support 10 de type SOI. La portion de contact 21 peut présenter une épaisseur comprise par exemple entre 220nm et 500nm.

La portion de multiplication 22 de la photodiode 20 est réalisée à base du premier matériau semiconducteur, et est de préférence intrinsèque (non intentionnellement dopé). Elle repose sur et au contact de la portion de contact 21, et plus précisément sur la zone centrale 21.1 de la portion de contact 21. Elle présente une surface dans le plan XY inférieure à celle de la zone centrale de contact. De préférence, elle est réalisée en silicium intrinsèque, et présente une épaisseur comprise par exemple entre 100nm et 300nm environ.

La zone de charge 23 de la photodiode 20 est une zone dopée de la portion de multiplication 22 et affleurant la face supérieure de celle-ci. Elle est dopée selon un deuxième type de conductivité opposé au premier type. Elle correspond ici à une zone en Si dopé p- située dans la portion de multiplication 22. Plus précisément, la zone de charge 23 s'étend dans le premier matériau semiconducteur de la portion de multiplication 22 à partir de la face supérieure de celle-ci. Elle affleure donc la face supérieure de la portion de multiplication 22, et elle est donc disposée entre la portion de multiplication 22 et la portion d'absorption 27. Elle présente une profondeur comprise par exemple entre 20nm et 100nm environ et un niveau de dopage compris par exemple entre 10¹⁸ et 10¹⁹ at/cm² environ. Elle présente une surface dans le plan XY inférieure à celle de la portion de multiplication 22. Plus précisément, elle présente un retrait périphérique dr_{zc} vis-à-vis de la bordure de la portion de multiplication 22. La valeur dr_{zc} est sensiblement constante suivant le pourtour de la photodiode 20. Elle peut être de l'ordre de 200nm. Par retrait périphérique, on entend une distance dr non nulle dans le plan XY séparant ici la bordure de la zone de charge 23 vis-à-vis de la bordure de la portion de multiplication 22. Le retrait est dit périphérique dans le sens où cette distance dr est non nulle sur tout le pourtour de la photodiode 20.

La portion d'absorption 27 de la photodiode 20 est une portion réalisée à base d'un deuxième matériau semiconducteur, différent du premier matériau semiconducteur. De préférence, la portion de multiplication 22 est réalisée à base de germanium, par exemple en germanium ou en ses composés. Elle peut ainsi être réalisée en germanium intrinsèque, ou comporter des puits quantiques par exemple en GeSn. Elle présente une épaisseur comprise entre 200nm et 1µm environ. Elle présente une surface dans le plan XY, à l'interface avec la zone de charge 23, inférieure à la surface de celle-ci. Plus précisément, elle présente un retrait périphérique drₚₐ vis-à-vis de la bordure de la zone de charge 23. La valeur drₚₐ est sensiblement constante suivant le pourtour de la photodiode 20. Elle peut être de l'ordre de 200nm. Dans cet exemple, sa surface augmente suivant la direction +Z, mais, en variante, elle peut rester sensiblement constante.

La photodiode 20 comporte également un premier espaceur 24 et un deuxième espaceur 26, qui reposent sur la portion de multiplication 22 suivant l'axe Z, et entourent la portion d'absorption 27 dans le plan XY.

Le premier espaceur 24 s'étend continûment, dans le plan XY, entre et au contact de la couche d'encapsulation 12 et du deuxième espaceur 26. Il permet de délimiter latéralement la surface de la zone de charge 23 dans le plan XY, lors de la réalisation de cette dernière, et plus précisément de définir la valeur dr_{zc} du retrait périphérique de la zone de charge 23 vis-à-vis de la bordure de la portion de multiplication 22. Il est réalisé en un premier matériau diélectrique adapté à être gravé sélectivement vis-à-vis du matériau de la couche d'encapsulation 12 et du premier matériau semiconducteur. Ainsi, dans le cas de la photonique sur silicium, où le matériau semiconducteur de la portion de multiplication 22 est du silicium et où le matériau d'encapsulation est un oxyde de silicium, le premier espaceur 24 peut être réalisé en un nitrure de silicium (par ex. Si₃N₄), entre autres. Il recouvre et est au contact d'une partie périphérique de la surface de la portion de multiplication 22. Le premier espaceur 24 présente une dimension transversale, dans le plan XY, qui, dans cet exemple, diminue suivant la direction +Z. Cette dimension transversale peut, en variante, rester sensiblement constante. Elle peut être de l'ordre de 200nm à l'interface avec la portion de multiplication 22. Cette valeur définit la distance dr_{zc} entre la bordure de la portion de multiplication 22 et la bordure de la zone de charge 23.

Le deuxième espaceur 26 s'étend continûment, dans le plan XY, entre et au contact du premier espaceur 24 et de la portion d'absorption 27. Il permet de délimiter latéralement la surface de la portion d'absorption 27 dans le plan XY, lors de la réalisation de cette dernière, et plus précisément de définir la valeur drₚₐ du retrait périphérique de la portion d'absorption 27 vis-à-vis de la bordure de la zone de charge 23. Il est réalisé en un deuxième matériau diélectrique distinct du premier matériau diélectrique, et est adapté à être gravé sélectivement vis-à-vis du matériau diélectrique du premier espaceur 24. Ainsi, dans le cas où le premier espaceur 24 est en un nitrure de silicium, le deuxième espaceur 26 peut être réalisé en un oxyde de silicium (par ex. SiO₂). Ainsi, le deuxième espaceur 26 recouvre une partie périphérique de la surface de la zone de charge 23. Il présente une dimension transversale, dans le plan XY, qui, dans cet exemple, diminue suivant la direction +Z. Cette dimension transversale peut, en variante, rester sensiblement constante suivant la direction +Z. Elle peut être de l'ordre de 200nm à l'interface avec la zone de charge 23. Cette valeur définit la distance drₚₐ entre la bordure de la zone de charge 23 et la bordure de la portion d'absorption 27.

La couche d'encapsulation 12 recouvre entièrement la photodiode 20, c'est-à-dire la portion de contact 21, la portion d'absorption 27, et les flancs de la photodiode 20 formés notamment par la bordure de la portion de multiplication 22 et par la bordure du premier espaceur 24. Elle est réalisée en un matériau diélectrique, par exemple en un oxyde de silicium. Elle présente de préférence un indice de réfraction identique ou similaire à celui du matériau de la couche isolante 11. Ainsi, la couche isolante 11 et la couche d'encapsulation 12 peuvent participer ensemble à former la gaine du guide d'onde 40.

La photodiode 20 comporte des vias conducteurs 2 et des plots électriques 3, qui permettent de polariser la photodiode 20 et ainsi collecter les porteurs photogénérés. Les plots électriques 3 reposent sur la couche d'encapsulation 12, et les vias conducteurs 2 traversent la couche d'encapsulation 12 pour relier électriquement les plots électriques 3 aux zones latérales 21.2 de la portion de contact 21 d'une part, et à la portion d'absorption 27 d'autre part.

Un guide d'onde 40 s'étend de manière parallèle au plan du substrat support 10, de manière à autoriser un couplage optique avec la photodiode 20. Dans cet exemple, il s'étend de manière coplanaire à la portion de contact 21, et est réalisé d'un seul tenant avec celle-ci. Il est formé d'un cœur en un matériau de haut indice de réfraction entouré d'une gaine en un matériau de bas indice de réfraction. Le cœur est ici réalisé en le même matériau de celui de la portion de contact 21, c'est-à-dire en silicium, et la gaine est formée par la couche isolante 11 et par la couche d'encapsulation 12, celles-ci étant réalisées en un oxyde de silicium.

Le guide d'onde 40 comporte avantageusement une zone d'élargissement 42 permettant d'optimiser le couplage optique entre le guide d'onde 40 et la photodiode 20. Le guide d'onde 40, dans cette zone d'élargissement 42, présente une augmentation de sa largeur dans le plan XY suivant la direction -X, d'une valeur nominale à une valeur pouvant être sensiblement égale à la largeur de la portion d'absorption 27. Corrélativement, la photodiode 20 comporte une zone de couplage 30 dans laquelle la portion de multiplication 22 et la portion d'absorption 27 s'étendent au moins partiellement sur la zone d'élargissement 42 du guide d'onde 40, et présentent une largeur qui diminue suivant la direction +X entre une valeur nominale et une valeur minimale en direction du guide d'onde 40. Ainsi, la zone d'élargissement 42 du guide d'onde 40 et la zone de couplage 30 de la photodiode 20 permettent au mode optique guidé de s'étaler spatialement en direction de la portion d'absorption 27, améliorant ainsi le couplage évanescent entre le guide d'onde 40 et la photodiode 20, et l'absorption du mode optique par celle-ci.

Ainsi, la photodiode 20 de type SACM-APD, en configuration mésa, est couplée optiquement à un guide d'onde intégré 40, et se distingue ainsi des photodiodes illuminées par la surface, c'est-à-dire ici suivant l'axe Z. La photodiode 20 et le guide d'onde 40 sont avantageusement réalisés dans le cadre de la technologie de la photonique intégrée sur silicium. La photodiode 20 présente un auto-alignement de la portion d'absorption 27 vis-à-vis de la zone de charge 23, et de la zone de charge 23 vis-à-vis de la portion de multiplication 22, cet auto-alignement étant obtenu par la présence des premier et deuxième espaceurs 24, 26, ces derniers permettant également de définir précisément la valeur des différents retraits périphériques. La photodiode 20 présente ainsi des propriétés optiques et/ou électroniques optimisées dans la mesure où les risques de désalignement relatif sont réduits voire écartés. Par ailleurs, comme détaillé par la suite, les espaceurs 24, 26 permettent de n'effectuer qu'une seule opération de photolithographie lors des étapes de réalisation de la portion de multiplication 22, de la zone de charge 23 et de la portion d'absorption 27.

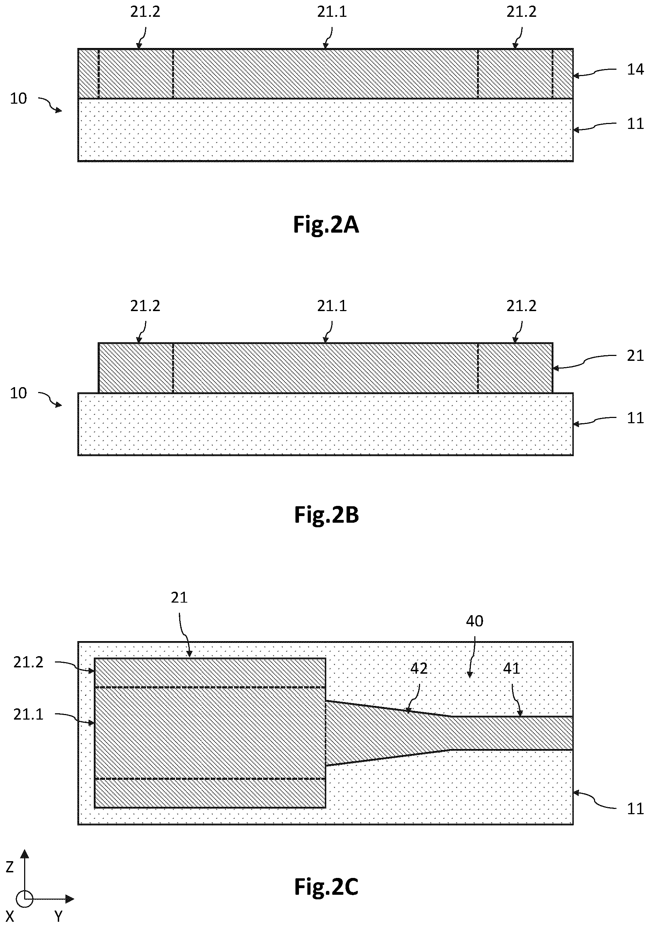

Un procédé de fabrication d'une puce photonique 1 telle qu'illustrée sur les figures 1A à 1C est maintenant décrit en référence aux figures 2A à 2N. Dans cet exemple, la photodiode 20 et le guide d'onde 40 sont réalisés dans le cadre de la technologie de la photonique intégrée sur silicium, et la photodiode 20 est du type germanium sur silicium. Autrement dit, dans cet exemple, le premier matériau semiconducteur est du silicium et le deuxième matériau semiconducteur est du germanium. Le premier espaceur 24 est réalisé en un nitrure de silicium et le deuxième espaceur 26 est réalisé en un oxyde de silicium.

Lors d'une première étape (figures 2A-2C), on réalise la portion de contact 21 de la photodiode 20, et notamment les zones centrale 21.1 et latérales 21.2 de la portion de contact 21. Par ailleurs, on peut également réaliser le guide d'onde intégré 40 de sorte que la photodiode 20 est couplée optiquement à un guide d'onde 40 qui s'étend de manière coplanaire à la portion de contact 21, et ici d'un seul tenant.

En référence à la fig.2A, on fournit un substrat support 10 comportant une couche 14 en le premier matériau semiconducteur reposant sur une couche isolante 11. De préférence, le substrat support 10 est un substrat SOI, c'est-à-dire qu'il comporte une couche en silicium 14 qui recouvre une couche en un oxyde de silicium (BOX pour *Buried Oxide*, en anglais). La couche de silicium 14 peut présenter une épaisseur de l'ordre de 220nm à 500nm environ, et la couche isolante 11 peut présenter une épaisseur de l'ordre de 700nm à 2000nm environ.

Ensuite, on réalise un dopage localisé dans la couche de silicium 14, par implantation ionique de dopants de sorte à obtenir une zone centrale 21.1 dopée n+ encadrée par deux zones latérales 21.2 dopées n++. Le niveau de dopage pour la zone centrale 21.1 en Si dopé n+ peut est compris entre 10¹⁷ et 10¹⁸ at/cm³ environ, et celui pour les zones latérales 21.2 en Si dopé n++ peut être supérieur ou égal à 10¹⁹ at/cm³ environ.

En référence aux fig.2B et 2C, on grave ensuite localement la couche de silicium 14 pour définir spatialement la portion de contact 21 dans le plan XY. La portion de contact 21 peut présenter une largeur de l'ordre de quelques microns (par ex. entre 2 et 10µm) et une longueur de l'ordre de quelques dizaines de microns (par ex. entre 5 et 30µm). La zone centrale 21.1 peut présenter une largeur de l'ordre de 0.5µm à 3µm et les zones latérales 21.2 une largeur de l'ordre de 1µ à 3 µm.

De préférence, le guide d'onde 40 peut être défini lors de la même étape de gravure. Il comporte ainsi une portion longitudinale nominale 41 et une zone d'élargissement 42. Il est ainsi réalisé d'un seul tenant avec la portion de contact 21 de la photodiode 20. Ainsi, le guide d'onde 40 s'étend dans un plan parallèle, et ici coplanaire, au plan de la portion de contact 21. Il y a donc couplage optique latéral entre le guide d'onde intégré 40 et la photodiode 20.

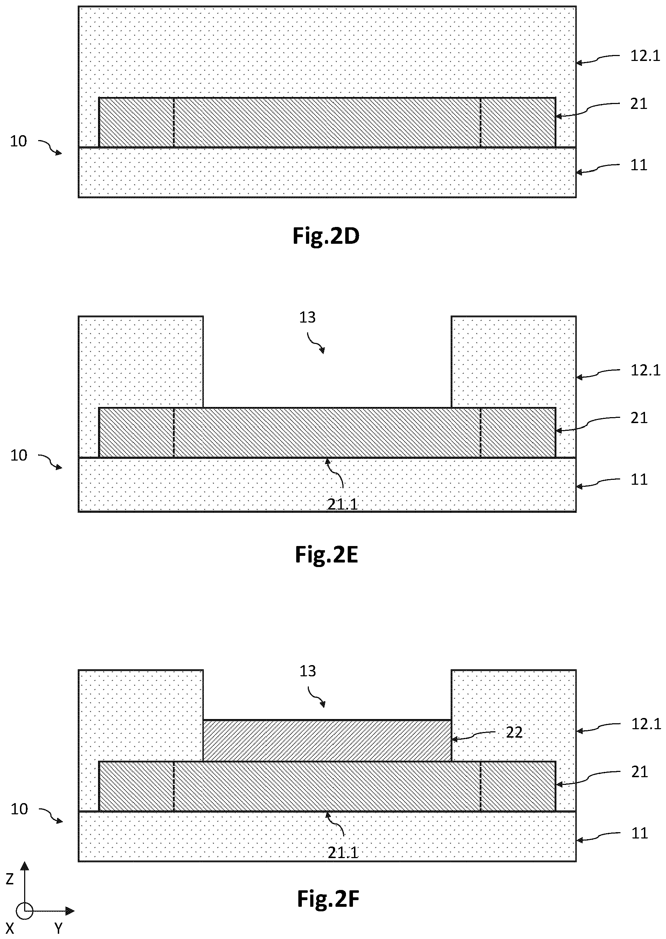

Dans une étape suivante (figures 2D à 2F), on réalise la portion de multiplication 22 de la photodiode 20. Pour cela, en référence à la fig.2D, on dépose une première couche d'encapsulation 12.1 en un matériau diélectrique de manière à recouvrir la portion de contact 21. Cette première couche d'encapsulation 12.1 peut également recouvrir le guide d'onde 40 et ainsi participer à former la gaine. Le matériau diélectrique est de préférence un matériau identique à celui de la couche isolante 11, c'est-à-dire ici un oxyde de silicium. L'épaisseur de la première couche d'encapsulation 12.1 est choisie de manière à être égale à la somme de l'épaisseur de la portion de multiplication 22 et de la hauteur des espaceurs 24, 26.

En référence à la fig.2E, on réalise ensuite, par photolithographie et gravure, une ouverture traversante 13 au travers de la première couche d'encapsulation 12.1, de manière à déboucher sur une surface de la portion de contact 21, au niveau de la zone centrale 21.1. Cette opération de photolithographie est la seule de l'ensemble des étapes de réalisation de la portion de multiplication 22, de la zone de charge 23, et de la portion d'absorption 27. L'ouverture traversante 13 présente des dimensions transversales, dans le plan XY, correspondant à celles définies de la portion de multiplication 22. Ainsi, la surface libre de la portion de contact 21 forme une surface de nucléation pour la croissance épitaxiale de la portion de multiplication 22.

En référence à la fig.2F, on réalise ensuite, par croissance épitaxiale, la portion de multiplication 22 à partir de la surface libre de la portion de contact 21. Par surface libre, on entend une surface non revêtue par un matériau quelconque. La portion de multiplication 22 est réalisée en le même matériau semiconducteur que celui de la portion de contact 21, à savoir ici en silicium. Il est de préférence intrinsèque, c'est-à-dire non intentionnellement dopé. La croissance peut être effectuée par les techniques classiques d'épitaxie, par exemple par épitaxie en phase vapeur (CVD pour *Chemical Vapor Deposition*, en anglais).

La portion de multiplication 22 présente une épaisseur inférieure à la hauteur de l'ouverture traversante 13, de sorte que la surface libre des flancs de l'ouverture traversante 13 sera ultérieurement mise à profit pour réaliser les espaceurs 24, 26. Pour cela, la croissance épitaxiale peut être réalisée de sorte que la portion de silicium épitaxié déborde hors de l'ouverture traversante 13. L'épitaxie est alors suivie d'une étape de planarisation mécano-chimique (CMP) permettant de supprimer la partie débordante de la portion de silicium épitaxié, et de supprimer le silicium éventuellement formé sur la face supérieure de la couche d'encapsulation 12.1. Une opération de gravure partielle de la portion épitaxiée (par ex. une gravure sèche) est ensuite effectuée. On obtient ainsi une portion de multiplication 22 en silicium intrinsèque, dont l'épaisseur est inférieure à la hauteur de l'ouverture traversante 13. En variante, la phase d'épitaxie peut être stoppée lorsqu'il est considéré que la portion de silicium épitaxié présente l'épaisseur voulue, cependant le fait de former une partie débordante de silicium épitaxié suivi d'une gravure partielle permet d'éviter la présence de facettes cristallographiques du silicium situées en bordure de l'ouverture 13.

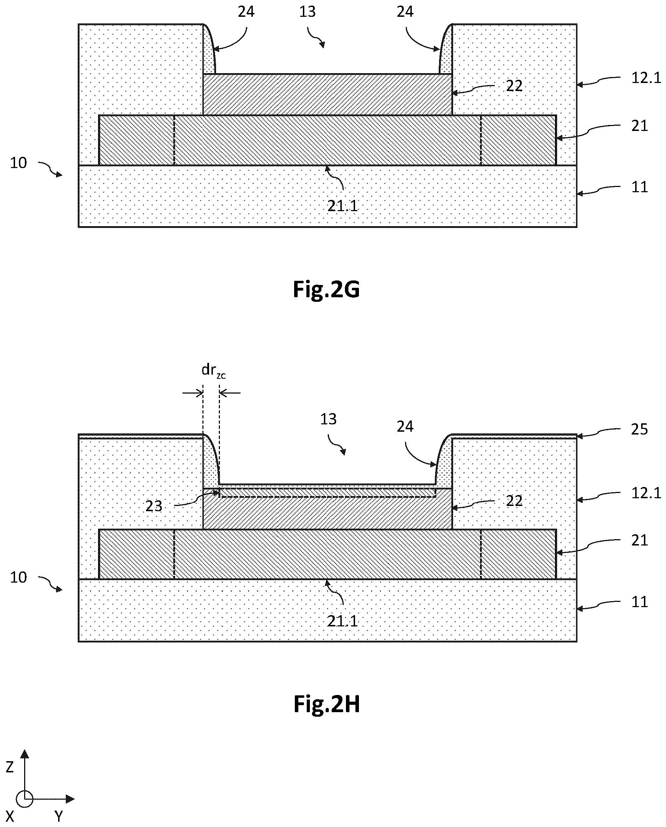

Dans une étape suivante (figure 2G), on réalise le premier espaceur 24. Pour cela, on dépose de manière conforme une première couche d'espacement (non représentée) en un premier matériau diélectrique, celui-ci étant adapté à être gravé de manière sélective vis-à-vis du matériau diélectrique de la première couche d'encapsulation 12.1, à savoir ici un oxyde de silicium, et vis-à-vis du matériau semiconducteur de la portion de multiplication 22, à savoir ici le silicium. Le premier matériau diélectrique est, dans cet exemple, un nitrure de silicium, par exemple le Si₃N₄. Cette première couche d'espacement revêt donc la face supérieure de la couche d'encapsulation 12.1, les flancs de l'ouverture traversante 13, et la surface libre de la portion de multiplication 22.

L'épaisseur de la première couche d'espacement permettra de définir la dimension transversale (épaisseur dans le plan XY) du premier espaceur 24, en particulier à l'interface avec la portion de multiplication 22. En effet, la dimension transversale de la première couche d'espacement, au niveau des flancs de l'ouverture traversante 13, peut varier suivant l'axe Z : elle peut présenter une valeur maximale à l'interface avec la portion de multiplication 22, et une valeur minimale au niveau du sommet de l'ouverture traversante 13. Cette valeur maximale de la dimension transversale de la première couche d'espacement permettra de définir la valeur dr_{zc} du retrait périphérique de la zone de charge 23 vis-à-vis de la bordure de la portion de multiplication 22.

On réalise ensuite une gravure anisotrope de la première couche d'espacement en Si₃N₄ de manière à supprimer la partie située sur la face supérieure de la couche d'encapsulation 12.1, et une partie centrale située sur la portion de multiplication 22. L'arrêt de gravure peut être effectué par détection de fin d'attaque sur l'oxyde de la couche d'encapsulation 12.1. Seule reste une partie périphérique, formant le premier espaceur 24, qui s'étend continûment sur les flancs de l'ouverture traversante 13 et recouvre continûment une partie périphérique de largeur constante de la surface de la portion de multiplication 22. La dimension transversale (épaisseur dans le plan XY) du premier espaceur 24, à l'interface avec la portion de multiplication 22, peut être par exemple de l'ordre de quelques centaines de nanomètres, et est avantageusement comprise entre 150nm et 250nm environ. Dans la mesure où la dimension transversale du premier espaceur, à l'interface avec la portion de multiplication 22, est constante suivant le pourtour de la photodiode, il en résulte donc que la partie périphérique de la surface de la portion de multiplication, recouverte par le premier espaceur 24, présente également une largeur constante suivant le pourtour de la photodiode.

Dans une étape suivante (figure 2H), on réalise la zone de charge 23 dans la portion de multiplication 22. Pour cela, on dépose avantageusement une couche mince de protection 25 en le premier matériau diélectrique, ici en SiN, de manière à recouvrir la surface libre de la portion de multiplication 22. Cette couche mince de protection 25 recouvre également la face supérieure de la couche d'encapsulation 12.1, ainsi que le premier espaceur 24. Elle permet de limiter la formation de défauts liés à l'implantation ionique dans le silicium de dopants lors de la réalisation de la zone de charge 23. On améliore ainsi les propriétés électriques de la zone de charge 23, et cela permet une meilleure reprise d'épitaxie du deuxième matériau semiconducteur, ici le germanium, lors de la réalisation de la portion d'absorption 27. La couche mince de protection 25 peut présenter une épaisseur par exemple de l'ordre de 10nm à 50nm.

On réalise ensuite la zone de charge 23 par implantation ionique de dopants dans la portion de multiplication 22 au travers de la couche mince de protection 25, dans une zone non recouverte par le premier espaceur 24. La zone implantée peut présenter une profondeur de l'ordre de quelques dizaines de nanomètres, par exemple comprise entre 20nm et 50nm environ. La zone de charge 23 présente ainsi un retrait périphérique dr_{zc} dans le plan XY par rapport à la bordure de la portion de multiplication 22, dont la distance correspond à la valeur maximale de la dimension transversale (épaisseur dans le plan XY) du premier espaceur 24 à l'interface avec la portion de multiplication 22. Cette distance dr_{zc} du retrait périphérique étant constante suivant le pourtour de la photodiode 20, il y a donc un auto-alignement de la zone de charge 23 vis-à-vis de la portion de multiplication 22. Cet auto-alignement est obtenu sans opération de photolithographie, mais par l'utilisation du premier espaceur 24.

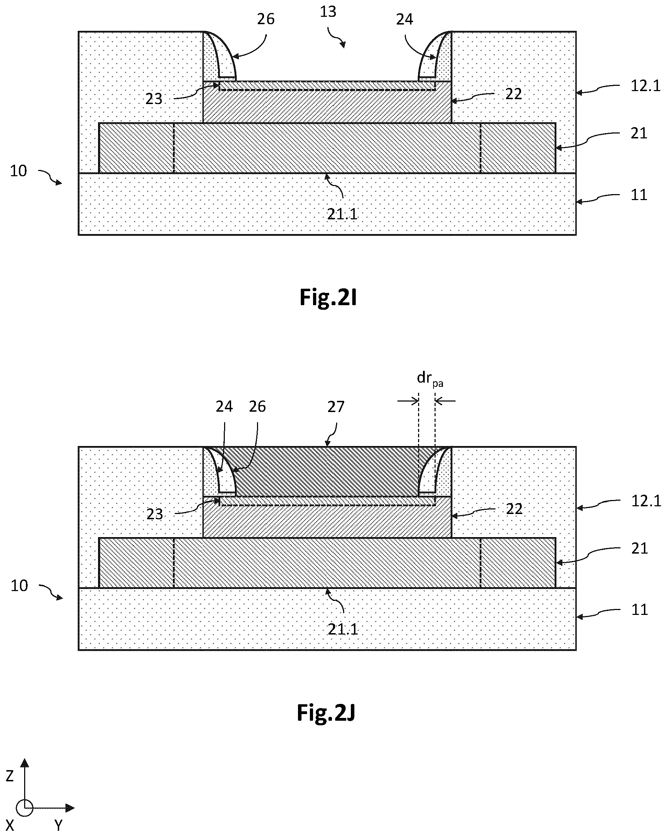

Dans une étape suivante (figure 2I), on réalise le deuxième espaceur 26. Pour cela, on dépose de manière conforme une deuxième couche d'espacement (non représentée) en un deuxième matériau diélectrique, celui-ci étant adapté à être gravé de manière sélective vis-à-vis du matériau diélectrique du premier espaceur 24, à savoir ici du nitrure de silicium. Le deuxième matériau diélectrique est, dans cet exemple, un oxyde de silicium. La deuxième couche d'espacement revêt donc la couche mince de protection 25, tant au niveau de la face supérieure de la couche d'encapsulation 12.1, que du premier espaceur 24, et de la zone de charge 23.

L'épaisseur de la deuxième couche d'espacement permettra de définir la dimension transversale (épaisseur dans le plan XY) du deuxième espaceur 26, en particulier à l'interface avec la zone de charge 23. En effet, la dimension transversale de la deuxième couche d'espacement, au niveau du premier espaceur 24, peut varier suivant l'axe Z : elle peut présenter une valeur maximale à l'interface avec la zone de charge 23, et une valeur minimale au niveau du sommet de l'ouverture traversante 13. Cette valeur maximale de la dimension transversale de la deuxième couche d'espacement permettra ainsi de définir la valeur drₚₐ du retrait périphérique de la portion d'absorption 27 vis-à-vis de la bordure de la zone de charge 23.

On réalise ensuite une gravure anisotrope de la deuxième couche d'espacement en SiO de manière à supprimer la partie située sur la face supérieure de la couche d'encapsulation 12.1, et une partie centrale située sur la portion de multiplication 22, en regard de la zone de charge 23. L'arrêt de gravure peut être effectué par détection de fin d'attaque sur le nitrure de silicium de la couche mince de protection 25. Seule reste donc une partie périphérique, formant le deuxième espaceur 26, qui s'étend continûment au contact du premier espaceur 24 et recouvre continûment une partie périphérique de largeur constante de la surface de la zone de charge 23 (dans la mesure où le deuxième espaceur 26 présente une dimension transversale (épaisseur dans le plan XY), à l'interface avec la zone de charge 23, constante). Le deuxième espaceur 26 présente une dimension transversale (épaisseur dans le plan XY), à l'interface avec la zone de charge 23, par exemple de l'ordre de quelques centaines de nanomètres, et avantageusement comprise entre 150nm et 250nm environ. Une gravure anisotrope de la couche mince de protection 25 est ensuite effectuée, celle-ci étant sélective vis-à-vis de l'oxyde de la couche d'encapsulation 12.1 et du silicium de la zone de charge 23. Notons qu'une partie de la couche mince de protection 25 n'est pas gravée lors de la gravure anisotrope : cette partie étant recouverte par le deuxième espaceur 26.

Dans une étape suivante (figure 2J), on réalise la portion d'absorption 27. Pour cela, on effectue la croissance épitaxiale d'un deuxième matériau semiconducteur, distinct du premier matériau semiconducteur. Dans le cadre d'une photodiode 20 de type SACM-APD et Ge/Si, la portion d'absorption 27 peut être réalisée en germanium intrinsèque, ou à base de germanium et ainsi comporter des puits quantiques par exemple en GeSn. Par « à base d'un élément chimique », on entend que le matériau correspond à cet élément chimique ou à ses composés chimiques. Dans cet exemple, la portion d'absorption 27 est réalisée en germanium intrinsèque. La croissance peut être effectuée par les techniques classiques d'épitaxie, par exemple par épitaxie en phase vapeur (CVD pour *Chemical Vapor Deposition*, en anglais).

De préférence, la portion d'absorption 27 affleure la face supérieure de la couche d'encapsulation 12.1. Pour cela, la phase d'épitaxie est réalisée de sorte que la portion de germanium épitaxié affleure ou déborde hors de l'ouverture traversante 13. L'épitaxie est alors suivie d'une étape de planarisation mécano-chimique (CMP) permettant de supprimer la partie débordante de la portion de germanium épitaxié, et de supprimer le germanium éventuellement formé sur la face supérieure de la couche d'encapsulation 12.1. On évite ainsi le phénomène de facettage du germanium épitaxié en bordure de la portion d'absorption 27.

On obtient ainsi une portion d'absorption 27 en germanium intrinsèque, située dans l'ouverture traversante 13 et délimitée dans le plan XY par le deuxième espaceur 26. Elle peut présenter une dimension transversale dans le plan XY qui augmente suivant la direction +Z dans la mesure où les premier et deuxième espaceurs 24, 26 présentent ici une dimension traversale qui diminue suivant la direction +Z. Quoi qu'il en soit, la portion d'absorption 27 présente un retrait périphérique drₚₐ dans le plan XY par rapport à la bordure de la zone de charge 23, dont la distance correspond à la dimension transversale du deuxième espaceur 26 à l'interface avec la zone de charge 23. Ce retrait périphérique drₚₐ étant constant suivant le pourtour de la photodiode 20, il y a donc un auto-alignement de la portion d'absorption 27 vis-à-vis de la zone de charge 23. Cet auto-alignement obtenu sans opération de photolithographie, mais par l'utilisation du deuxième espaceur 26.

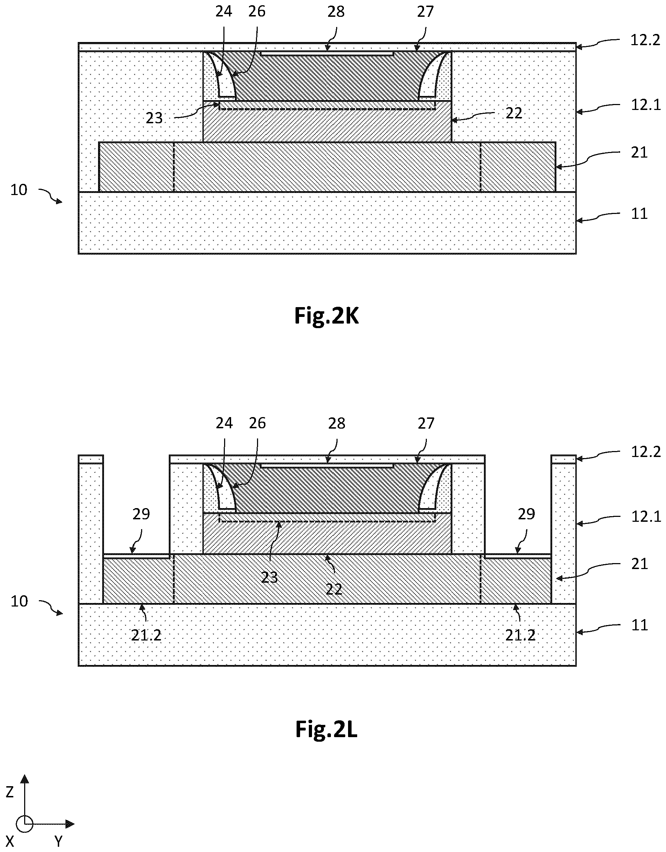

Dans une étape suivante (figures 2K à 2N), on finalise la réalisation de la photodiode 20. Ainsi, en référence à la fig.2K, on réalise avantageusement une zone de contact 28 en germanium dopée p++ dans la portion d'absorption 27. Pour cela, on dépose une couche de protection 12.2, ici en un oxyde de silicium, de manière à recouvrir la portion d'absorption 27. La couche de protection 12.2 est une couche mince dont l'épaisseur peut être de l'ordre de 50nm. La zone de contact 28 est ensuite formée par implantation ionique de dopants dans le germanium de la portion d'absorption 27, de manière à obtenir un zone localisée dopée p++. Un recuit d'activation des dopants est ensuite réalisé.

En référence à la fig.2L, on réalise avantageusement des zones de contact 29 en silicium dopé n++ dans les zones latérales 21.2 de la portion de contact 21. Ces zones de contact 29 en Si dopé n++ peuvent être réalisées par siliciuration, après avoir réalisé des ouvertures traversantes au travers de l'oxyde d'encapsulation de manière à rendre libre une surface des zones latérales 21.2 de la portion de contact 21. Cette étape peut, en variante, être réalisée plus tôt dans le procédé de fabrication, par exemple avant la réalisation de la portion de multiplication 22. Les zones de contact 28, 29 (Ge dopé p++ et Si dopé n++) permettent de réduire la résistance d'accès.

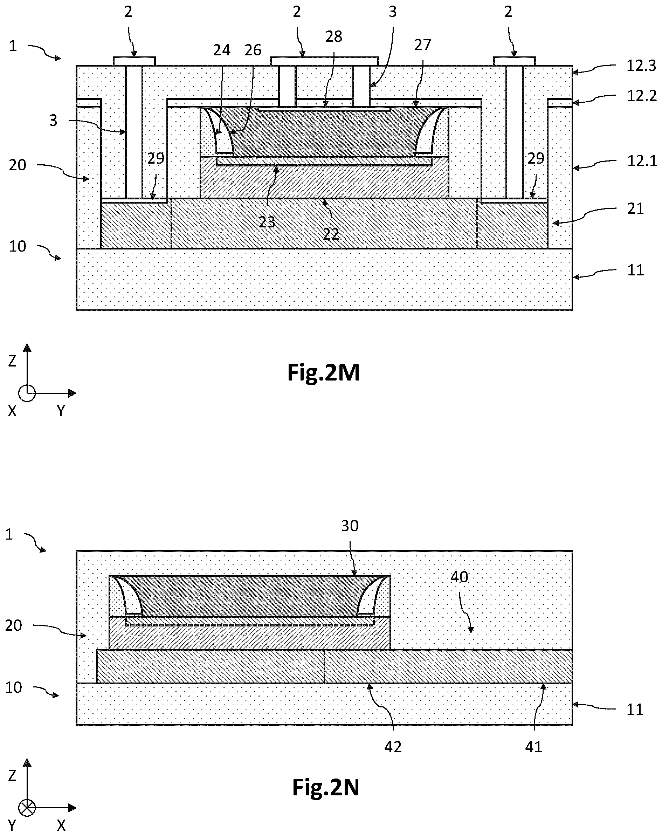

En référence aux fig.2M et 2N, on réalise ensuite un dépôt d'une deuxième couche d'encapsulation 12.3, en un oxyde identique ou similaire à celui de la première couche d'encapsulation 12.1, de manière à reboucher les ouvertures traversantes. Puis des vias conducteurs 2, réalisés en au moins un matériau électriquement conducteur, sont réalisés au travers de l'oxyde d'encapsulation, pour venir contacter la zone de contact 28 en Ge dopé p++ et les zones de contact 29 en Si dopé n++. Des plots électriques 3 sont ensuite réalisés sur la face supérieure de la couche d'encapsulation 12.3, de manière à être au contact des vias conducteurs 2.

Ainsi, par le procédé de fabrication selon l'invention, on obtient une photodiode 20 de type SACM-APD en configuration en mésa et couplée optiquement à un guide d'onde intégré 40, dont la portion d'absorption 27, la zone de charge 23, et la portion de multiplication 22 sont auto-alignées, et dont les différents retraits périphériques sont définis par les premier et deuxième espaceurs 24, 26, et non pas par des étapes de photolithographie. Les propriétés optiques et/ou électroniques de la photodiode 20 sont donc optimisées, et les risques de claquage en bordure de la photodiode 20 sont particulièrement réduits. Par ailleurs, le procédé permet d'éviter les inconvénients associés à la mise en œuvre de plusieurs opérations de photolithographie successives pour définir le positionnement relatif de la portion de multiplication 22, de la zone de charge 23 et de la portion d'absorption 27.

Des modes de réalisation particuliers viennent d'être décrits. Différentes variantes et modifications apparaîtront à l'homme du métier, sans s'écarter de la portée des revendications. Ainsi, les types de conductivité peuvent être inversés, et les niveaux de dopage des matériaux semiconducteurs peuvent être modifiés.

## Revendications

1. Procédé de fabrication d'une puce photonique (1) comportant au moins une photodiode (20) de type SACM-APD reposant sur un substrat support (10), et un guide d'onde (40) s'étendant de manière parallèle au substrat support (10) et couplé optiquement à la photodiode (20), comportant les étapes suivantes :
o réalisation d'une portion de contact (21) en un premier matériau semiconducteur dopé selon un premier type de conductivité, à partir d'une couche (14) du premier matériau semiconducteur reposant sur une couche isolante (11) du substrat support (10) ;
o dépôt d'une couche d'encapsulation (12.1) recouvrant la portion de contact (21), et réalisation d'une ouverture traversante (13) au travers de la couche d'encapsulation (12.1) débouchant sur une surface de la portion de contact (21) ;
o réalisation, dans l'ouverture traversante (13), d'une portion de multiplication (22) en le premier matériau semiconducteur à partir de la surface de la portion de contact (21), la portion de multiplication (22) présentant une épaisseur inférieure à une hauteur de l'ouverture traversante (13) ;
o réalisation d'un premier espaceur (24) en un premier matériau diélectrique, de sorte qu'il recouvre les flancs de l'ouverture traversante (13) ainsi qu'une partie périphérique de largeur constante d'une surface de la portion de multiplication (22) ;
o réalisation d'une zone de charge (23) dans la portion de multiplication (22) et affleurant une face supérieure de celle-ci, la zone de charge (23) étant délimitée latéralement par le premier espaceur (24) de sorte qu'elle présente un retrait périphérique constant dr_{zc} vis-à-vis d'une bordure de la portion de multiplication (22) ;
o réalisation d'un deuxième espaceur (26) en un deuxième matériau diélectrique, distinct du premier matériau diélectrique, de sorte qu'il recouvre le premier espaceur (24) ainsi qu'une partie périphérique de largeur constante d'une surface de la zone de charge (23) ;
o réalisation d'une portion d'absorption (27) en un deuxième matériau semiconducteur, à partir d'une surface libre de la zone de charge (23), la portion d'absorption (27) étant délimitée latéralement, à l'interface avec la zone de charge (23), par le deuxième espaceur (26) de sorte qu'elle présente un retrait périphérique constant drₚₐ vis-à-vis d'une bordure de la zone de charge (23).

2. Procédé de fabrication selon la revendication 1, dans lequel le premier matériau diélectrique est adapté à être gravé sélectivement vis-à-vis du matériau de la couche d'encapsulation (12.1) et du premier matériau semiconducteur, et le deuxième matériau diélectrique est adapté à être gravé sélectivement vis-à-vis du premier matériau diélectrique.

3. Procédé de fabrication selon la revendication 2, l'étape de réalisation du premier espaceur (24) comportant :
o un dépôt conforme d'une première couche d'espacement en le premier matériau diélectrique, de manière à recouvrir une face supérieure de la couche d'encapsulation (12.1), les flancs de l'ouverture traversante (13), et la surface de la portion de multiplication (22), l'épaisseur de la première couche d'espacement définissant ultérieurement la valeur dr_{zc} du retrait périphérique de la zone de charge (23) vis-à-vis de la portion de multiplication (22) ;
o une gravure anisotrope de la première couche d'espacement, de manière à rendre libre la face supérieure de la couche d'encapsulation (12.1) ainsi qu'une partie centrale d'une surface de la portion de multiplication (22), et à ne conserver qu'une partie périphérique formant ledit premier espaceur (24).

4. Procédé de fabrication selon la revendication 2 ou 3, dans lequel l'étape de réalisation du deuxième espaceur (26) comporte :
o un dépôt conforme d'une couche mince de protection (25) en le premier matériau diélectrique, de manière à recouvrir la couche d'encapsulation (12.1), le premier espaceur (24), et la zone de charge (23) ;
o un dépôt conforme d'une deuxième couche d'espacement en le deuxième matériau diélectrique, de manière à recouvrir la couche mince de protection (25), l'épaisseur de la deuxième couche d'espacement définissant ultérieurement la valeur drₚₐ du retrait périphérique de la portion d'absorption (27) vis-à-vis de la zone de charge (23) ;
o une gravure anisotrope de la deuxième couche d'espacement, de manière à rendre libre une surface de la couche mince de protection (25) située sur la face supérieure de la couche d'encapsulation (12.1) ainsi qu'une partie centrale située sur la zone de charge (23), et à ne conserver qu'une partie périphérique formant ledit deuxième espaceur (26) ;
o une gravure anisotrope de la couche mince de protection (25), de manière à rendre libre la face supérieure de la première couche d'encapsulation (12.1) ainsi qu'une partie centrale d'une surface de la zone de charge (23).

5. Procédé de fabrication selon la revendication 4, dans lequel la zone de charge (23) est réalisée entre le dépôt conforme de la couche mince de protection (25) et le dépôt conforme de la deuxième couche d'espacement, par implantation ionique de dopants dans la portion de multiplication (22) au travers de la couche mince de protection (25).

6. Procédé de fabrication selon l'une quelconque des revendications 1 à 5, dans lequel l'étape de réalisation de la portion de multiplication (22) comporte une épitaxie du deuxième matériau semiconducteur de sorte que le matériau épitaxié déborde hors de l'ouverture traversante (13), suivie d'une étape de planarisation mécano-chimique du matériau épitaxié puis d'une gravure partielle du matériau épitaxié, de manière à former la portion de multiplication (22).

7. Procédé de fabrication selon l'une quelconque des revendications 1 à 6, dans lequel le guide d'onde (40) est réalisé à partir de la couche (14) du premier matériau semiconducteur, et s'étend de manière coplanaire et d'un seul tenant avec la portion de contact (21).

8. Procédé de fabrication selon l'une quelconque des revendications 1 à 7, comportant les étapes suivantes :
∘ dépôt d'une couche d'encapsulation supplémentaire (12.3) recouvrant la portion d'absorption (27) ;
∘ réalisation de vias conducteurs (2) et de plots électriques (3), les plots électriques (3) reposant sur les couches d'encapsulations (12.1, 12.3), et les vias conducteurs (2) reliant la portion de contact (21) et la portion d'absorption (27) aux plots électriques (3).

9. Puce photonique (1) comportant au moins une photodiode (20) de type SACM-APD reposant sur un substrat support (10) et un guide d'onde (40) s'étendant de manière parallèle au substrat support (10) et couplé optiquement à la photodiode (20), la photodiode (20) comportant un empilement formé de :
∘ une portion de contact (21) en un premier matériau semiconducteur dopé selon un premier type de conductivité, reposant sur une couche isolante (11) du substrat support (10) ;
∘ une couche d'encapsulation (12.1), recouvrant la portion de contact (21) et présentant une ouverture traversante (13) débouchant sur la portion de contact (21) ;
∘ une portion de multiplication (22), reposant sur et au contact de la portion de contact (21), et située dans l'ouverture traversante (13) ;
∘ une zone de charge (23), située dans la portion de multiplication (22) et affleurant une face supérieure de celle-ci, et délimitée latéralement par un premier espaceur (24) en un premier matériau diélectrique s'étendant au contact des flancs de l'ouverture traversante (13) de sorte que la zone de charge (23) présente un retrait périphérique constant dr_{zc} vis-à-vis d'une bordure de la portion de multiplication (22) ;
∘ une portion d'absorption (27), reposant sur et au contact de la zone de charge (23), et située dans l'ouverture traversante (13), et délimitée latéralement, à l'interface avec la zone de charge (23), par un deuxième espaceur (26) en un deuxième matériau diélectrique distinct du premier matériau diélectrique et s'étendant entre et au contact du premier espaceur (24) et de la portion d'absorption (27), de sorte que la portion d'absorption (27) présente un retrait périphérique constant drₚₐ vis-à-vis d'une bordure de la zone de charge (23).

10. Puce photonique (1) selon la revendication 9, dans lequel la portion d'absorption (27) est réalisée à base de germanium, et la portion de multiplication (22) et la portion de contact (21) sont réalisées en silicium.

11. Puce photonique (1) selon la revendication 9 ou 10, dans lequel le premier espaceur (24) est réalisé en un nitrure de silicium, et le deuxième espaceur (26) est réalisé en un oxyde de silicium.

12. Puce photonique (1) selon l'une quelconque des revendications 9 à 11, dans lequel le guide d'onde (40) est coplanaire et réalisé d'un seul tenant avec la portion de contact (21).

13. Puce photonique (1) selon l'une quelconque des revendications 9 à 12, dans lequel le guide d'onde (40) comporte une zone d'élargissement (42) dans laquelle sa largeur augmente en direction de la portion de contact (21), et la photodiode (20) comporte une zone de couplage (41) formée par la portion de multiplication (22), la zone de charge (23) et la portion d'absorption (27), et située en regard de la zone d'élargissement (42), dont la largeur diminue en direction du guide d'onde (40).

## Patentansprüche

1. Verfahren zur Herstellung eines photonischen Chips (1), der mindestens eine Avalanche-Photodiode (20) mit SACM-Struktur, die auf einem Trägersubstrat (10) ruht, und einen Wellenleiter (40), der sich parallel zu dem Trägersubstrat (10) erstreckt und mit der Photodiode (20) optisch gekoppelt ist, aufweist, die folgenden Schritte umfassend:
∘ Herstellung eines Kontaktabschnitts (21) aus einem ersten Halbleitermaterial, das gemäß einem ersten Leitfähigkeitstyp dotiert ist, ausgehend von einer Schicht (14) des ersten Halbleitermaterials, die auf einer Isolierschicht (11) des Trägersubstrats (10) ruht;
∘ Aufbringung einer Verkapselungsschicht (12.1), die den Kontaktabschnitt (21) bedeckt, und Herstellung einer Durchgangsöffnung (13) durch die Verkapselungsschicht (12.1), die auf einer Oberfläche des Kontaktabschnitts (21) mündet;
∘ Herstellung, in der Durchgangsöffnung (13), eines Multiplikationsabschnitts (22) aus dem ersten Halbleitermaterial ausgehend von der Oberfläche des Kontaktabschnitts (21), wobei der Multiplikationsabschnitt (22) eine Dicke aufweist, die kleiner als eine Höhe der Durchgangsöffnung (13) ist;
∘ Herstellung eines ersten Spacers (24) aus einem ersten dielektrischen Material, derart, dass er die Seitenflächen der Durchgangsöffnung (13) sowie einen peripheren Teil konstanter Breite einer Oberfläche des Multiplikationsabschnitts (22) bedeckt;
∘ Herstellung eines Ladebereichs (23) in dem Multiplikationsabschnitt (22), der mit einer Oberseite des Letzteren bündig ist, wobei der Ladebereich (23) seitlich von dem ersten Spacer (24) begrenzt wird, derart, dass er in Bezug auf einen Rand des Multiplikationsabschnitts (22) einen konstanten Rückversatz entlang des Umfangs dr_{zc} aufweist;
∘ Herstellung eines zweiten Spacers (26) aus einem zweiten dielektrischen Material, das von dem ersten dielektrischen Material verschieden ist, derart, dass er den ersten Spacer (24) sowie einen peripheren Teil konstanter Breite einer Oberfläche des Ladebereichs (23) bedeckt;
∘ Herstellung eines Absorptionsabschnitts (27) aus einem zweiten Halbleitermaterial ausgehend von einer freien Fläche des Ladebereichs (23), wobei der Absorptionsabschnitt (27) seitlich, an der Grenzfläche mit dem Ladebereich (23), von dem zweiten Spacer (26) begrenzt wird, derart, dass er in Bezug auf einen Rand des Ladebereichs (23) einen konstanten Rückversatz entlang des Umfangs drₚₐ aufweist.

2. Herstellungsverfahren nach Anspruch 1, wobei das erste dielektrische Material geeignet ist, in Bezug auf das Material der Verkapselungsschicht (12.1) und das erste Halbleitermaterial selektiv geätzt zu werden, und das zweite dielektrische Material geeignet ist, in Bezug auf das erste dielektrische Material selektiv geätzt zu werden.

3. Herstellungsverfahren nach Anspruch 2, wobei der Schritt der Herstellung des ersten Spacers (24) umfasst:
∘ eine konforme Abscheidung einer ersten Abstandsschicht aus dem ersten dielektrischen Material, so dass sie eine Oberseite der Verkapselungsschicht (12.1), die Seitenflächen der Durchgangsöffnung (13) und die Oberfläche des Multiplikationsabschnitts (22) bedeckt, wobei die Dicke der ersten Abstandsschicht später den Wert dr_{zc} des Rückversatzes des Ladebereichs (23) entlang des Umfangs in Bezug auf den Multiplikationsabschnitt (22) definiert;
∘ eine anisotrope Ätzung der ersten Abstandsschicht, um so die Oberseite der Verkapselungsschicht (12.1) sowie einen zentralen Teil einer Oberfläche des Multiplikationsabschnitts (22) freizulegen und nur einen peripheren Teil zu erhalten, der den ersten Spacer (24) bildet.

4. Herstellungsverfahren nach Anspruch 2 oder 3, wobei der Schritt der Herstellung des zweiten Spacers (26) umfasst:
∘ eine konforme Abscheidung einer dünnen Schutzschicht (25) aus dem ersten dielektrischen Material, so dass sie die Verkapselungsschicht (12.1), den ersten Spacer (24) und den Ladebereich (23) bedeckt;
∘ eine konforme Abscheidung einer zweiten Abstandsschicht aus dem zweiten dielektrischen Material, so dass sie die dünne Schutzschicht (25) bedeckt, wobei die Dicke der zweiten Abstandsschicht später den Wert drₚₐ des Rückversatzes des Absorptionsabschnitts (27) entlang des Umfangs in Bezug auf den Ladebereich (23) definiert;
∘ eine anisotrope Ätzung der zweiten Abstandsschicht, um so eine Fläche der dünnen Schutzschicht (25), die sich auf der Oberseite der Verkapselungsschicht (12.1) befindet, sowie einen zentralen Teil, der sich auf dem Ladebereich (23) befindet, freizulegen und nur einen peripheren Teil zu erhalten, der den zweiten Spacer (26) bildet;
∘ eine anisotrope Ätzung der dünnen Schutzschicht (25), um so die Oberseite der ersten Verkapselungsschicht (12.1) sowie einen zentralen Teil einer Oberfläche des Ladebereichs (23) freizulegen.

5. Herstellungsverfahren nach Anspruch 4, wobei der Ladebereich (23) zwischen der konformen Abscheidung der dünnen Schutzschicht (25) und der konformen Abscheidung der zweiten Abstandsschicht durch Ionenimplantation von Dotierstoffen durch die dünne Schutzschicht (25) hindurch in den Multiplikationsabschnitt (22) hergestellt wird.

6. Herstellungsverfahren nach einem der Ansprüche 1 bis 5, wobei der Schritt der Herstellung des Multiplikationsabschnitts (22) eine Epitaxie des zweiten Halbleitermaterials umfasst, derart, dass das epitaktisch aufgewachsene Material aus der Durchgangsöffnung (13) austritt, gefolgt von einem Schritt der mechanischchemischen Planarisierung des epitaktisch aufgewachsenen Materials und anschließend einer teilweisen Ätzung des epitaktisch aufgewachsenen Materials, um so den Multiplikationsabschnitts (22) auszubilden.

7. Herstellungsverfahren nach einem der Ansprüche 1 bis 6, wobei der Wellenleiter (40) ausgehend von der Schicht (14) des ersten Halbleitermaterials hergestellt wird und sich koplanar mit dem Kontaktabschnitt (21) erstreckt und mit diesem aus einem Stück besteht.

8. Herstellungsverfahren nach einem der Ansprüche 1 bis 7, die folgenden Schritte umfassend:
∘ Aufbringung einer zusätzlichen Verkapselungsschicht (12.3), die den Absorptionsabschnitt (27) bedeckt;
∘ Herstellung von leitenden Durchkontaktierungen (2) und elektrischen Anschlussflächen (3), wobei die elektrischen Anschlussflächen (3) auf den Verkapselungsschichten (12.1, 12.3) ruhen und die leitenden Durchkontaktierungen (2) den Kontaktabschnitt (21) und den Absorptionsabschnitt (27) mit den elektrischen Anschlussflächen (3) verbinden.

9. Photonischer Chip (1), welcher mindestens eine Avalanche-Photodiode (20) mit SACM-Struktur, die auf einem Trägersubstrat (10) ruht, und einen Wellenleiter (40), der sich parallel zu dem Trägersubstrat (10) erstreckt und mit der Photodiode (20) optisch gekoppelt ist, aufweist, wobei die Photodiode (20) einen Stapel umfasst, der gebildet wird von:
∘ einem Kontaktabschnitt (21) aus einem gemäß einem ersten Leitfähigkeitstyp dotierten ersten Halbleitermaterial, der auf einer Isolierschicht (11) des Trägersubstrats (10) ruht;
∘ einer Verkapselungsschicht (12.1), die den Kontaktabschnitt (21) bedeckt und eine Durchgangsöffnung (13) aufweist, die auf dem Kontaktabschnitt (21) mündet;
∘ einem Multiplikationsabschnitt (22), der auf dem Kontaktabschnitt (21) ruht und mit diesem in Kontakt steht und sich in der Durchgangsöffnung (13) befindet;
∘ einem Ladebereich (23), der sich in dem Multiplikationsabschnitt (22) befindet und mit einer Oberseite desselben bündig ist und seitlich von einem ersten Spacer (24) aus einem ersten dielektrischen Material begrenzt wird, der sich im Kontakt mit den Seitenflächen der Durchgangsöffnung (13) erstreckt, derart, dass der Ladebereich (23) in Bezug auf einen Rand des Multiplikationsabschnitts (22) einen konstanten Rückversatz entlang des Umfangs dr_{zc} aufweist;
∘ einem Absorptionsabschnitt (27), der auf dem Ladeabschnitt (23) ruht und mit diesem in Kontakt steht und sich in der Durchgangsöffnung (13) befindet und seitlich, an der Grenzfläche mit dem Ladebereich (23), von einem zweiten Spacer (26) aus einem zweiten dielektrischen Material, das von dem ersten dielektrischen Material verschieden ist, begrenzt wird, der sich zwischen dem ersten Spacer (24) und dem Absorptionsabschnitt (27) und in Kontakt mit diesen erstreckt, derart, dass der Absorptionsabschnitt (27) in Bezug auf einen Rand des Ladebereichs (23) einen konstanten Rückversatz entlang des Umfangs drₚₐ aufweist.

10. Photonischer Chip (1) nach Anspruch 9, wobei der Absorptionsabschnitt (27) auf der Basis von Germanium hergestellt ist und der Multiplikationsabschnitt (22) und der Kontaktabschnitt (21) aus Silizium hergestellt sind.

11. Photonischer Chip (1) nach Anspruch 9 oder 10, wobei der erste Spacer (24) aus einem Siliziumnitrid hergestellt ist und der zweite Spacer (26) aus einem Siliziumoxid hergestellt ist.

12. Photonischer Chip (1) nach einem der Ansprüche 9 bis 11, wobei der Wellenleiter (40) mit dem Kontaktabschnitt (21) koplanar ist und mit ihm aus einem Stück hergestellt ist.

13. Photonischer Chip (1) nach einem der Ansprüche 9 bis 12, wobei der Wellenleiter (40) einen Verbreiterungsbereich (42) aufweist, in welchem sich seine Breite in Richtung des Kontaktabschnitts (21) vergrößert, und die Photodiode (20) einen Kopplungsbereich (41) aufweist, der von dem Multiplikationsabschnitt (22), dem Ladebereich (23) und dem Absorptionsabschnitt (27) gebildet wird und sich gegenüber dem Verbreiterungsbereich (42) befindet und dessen Breite sich in Richtung des Wellenleiters (40) verringert.

## Claims

1. Method of fabrication of a photonic chip (1) comprising at least one photodiode (20) of the SACM-APD type lying on a carrier substrate (10), and a waveguide (40) extending parallel to the carrier substrate (10) and optically coupled to the photodiode (20), comprising the following steps:
∘ formation of a contact portion (21) made of a first semiconductor material doped according to a first type of conductivity, starting from a layer (14) of the first semiconductor material lying on an insulating layer (11) of the carrier substrate (10);
∘ deposition of an encapsulation layer (12.1) covering the contact portion (21), and formation of a through-opening (13) through the encapsulation layer (12.1) opening onto a surface of the contact portion (21);
∘ formation, in the through-opening (13), of a multiplication portion (22) made of the first semiconductor material starting from the surface of the contact portion (21), the multiplication portion (22) having a thickness less than a height of the through-opening (13);
∘ formation of a first spacer (24) made of a first dielectric material, such that it covers the sides of the through-opening (13) together with a peripheral part of constant width of a surface of the multiplication portion (22);
∘ formation of a charge region (23) in the multiplication portion (22) and flush with an upper face of the latter, the charge region (23) being bounded laterally by the first spacer (24) such that it exhibits a constant peripheral recessing dr_{zc} with respect to an edge of the multiplication portion (22);
∘ formation of a second spacer (26) made of a second dielectric material, distinct from the first dielectric material, such that it covers the first spacer (24) together with a peripheral part of constant width of a surface of the charge region (23);
∘ formation of an absorption portion (27) made of a second semiconductor material, starting from a free surface of the charge region (23), the absorption portion (27) being bounded laterally, at the interface with the charge region (23), by the second spacer (26) such that its periphery is recessed by a constant amount drₚₐ with respect to an edge of the charge region (23).

2. Fabrication method according to Claim 1, in which the first dielectric material is designed to be selectively etched with respect to the material of the encapsulation layer (12.1) and to the first semiconductor material, and the second dielectric material is designed to be selectively etched with respect to the first dielectric material.

3. Fabrication method according to Claim 2, the step for forming the first spacer (24) comprising:
∘ a conformal deposition of a first spacer layer of the first dielectric material, in such a manner as to cover an upper face of the encapsulation layer (12.1), the sides of the through-opening (13) and the surface of the multiplication portion (22), the thickness of the first spacer layer defining later on the value dr_{zc} of the peripheral recessing of the charge region (23) with respect to the multiplication portion (22);
∘ an anisotropic etch of the first spacer layer, in such a manner as to liberate the upper face of the encapsulation layer (12.1) together with a central part of a surface of the multiplication portion (22), and to only conserve a peripheral part forming said first spacer (24).

4. Fabrication method according to Claim 2 or 3, in which the step for forming the second spacer (26) comprises:
∘ a conformal deposition of a thin protective layer (25) of the first dielectric material, in such a manner as to cover the encapsulation layer (12.1), the first spacer (24), and the charge region (23);
∘ a conformal deposition of a second spacer layer of the second dielectric material, in such a manner as to cover the thin protective layer (25), the thickness of the second spacer layer defining later on the value drₚₐ of the peripheral recessing of the absorption portion (27) with respect to the charge region (23);
∘ an anisotropic etch of the second spacer layer, in such a manner as to liberate a surface area of the thin protective layer (25) situated on the upper face of the encapsulation layer (12.1) together with a central part situated on the charge region (23), and to only conserve a peripheral part forming said second spacer (26);
∘ an anisotropic etch of the thin protective layer (25), in such a manner as to liberate the upper face of the first encapsulation layer (12.1) together with a central part of a surface of the charge region (23).

5. Fabrication method according to Claim 4, in which the charge region (23) is formed between the conformal deposition of the thin protective layer (25) and the conformal deposition of the second spacer layer, by ion implantation of dopants into the multiplication portion (22) through the thin protective layer (25).

6. Fabrication method according to any one of Claims 1 to 5, in which the step for forming the multiplication portion (22) comprises an epitaxy of the second semiconductor material such that the epitaxied material spills out from the through-opening (13), followed by a step for chemical-mechanical planarization of the epitaxied material then by a partial etch of the epitaxied material, in such a manner as to form the multiplication portion (22).

7. Fabrication method according to any one of Claims 1 to 6, in which the waveguide (40) is formed starting from the layer (14) of the first semiconductor material, and extends in a coplanar manner and contiguously with the contact portion (21).

8. Fabrication method according to any one of Claims 1 to 7, comprising the following steps:
∘ deposition of an additional encapsulation layer (12.3) covering the absorption portion (27);
∘ formation of conducting vias (2) and of electrical studs (3), the electrical studs (3) lying on the encapsulation layers (12.1, 12.3), and the conducting vias (2) connecting the contact portion (21) and the absorption portion (27) to the electrical studs (3).

9. Photonic chip (1) comprising at least one photodiode (20) of the SACM-APD type lying on a carrier substrate (10) and a waveguide (40) extending parallel to the carrier substrate (10) and optically coupled to the photodiode (20), the photodiode (20) comprising a stack composed of:
∘ a contact portion (21) made of a first semiconductor material doped according to a first type of conductivity, lying on an insulating layer (11) of the carrier substrate (10);
∘ an encapsulation layer (12.1), covering the contact portion (21) and having a through-opening (13) opening onto the contact portion (21);
∘ a multiplication portion (22), lying on and in contact with the contact portion (21), and situated in the through-opening (13);
∘ a charge region (23), situated in the multiplication portion (22) and flush with an upper face of the latter, and laterally bounded by a first spacer (24) made of a first dielectric material extending in contact with the sides of the through-opening (13) such that the charge region (23) has a constant peripheral recessing dr_{zc} with respect to an edge of the multiplication portion (22);
∘ an absorption portion (27), lying on and in contact with the charge region (23), and situated in the through-opening (13), and laterally bounded, at the interface with the charge region (23), by a second spacer (26) made of a second dielectric material distinct from the first dielectric material and extending between and in contact with the first spacer (24) and with the absorption portion (27), such that the absorption portion (27) has a constant peripheral recessing drₚₐ with respect to an edge of the charge region (23).

10. Photonic chip (1) according to Claim 9, in which the absorption portion (27) is formed using germanium, and the multiplication portion (22) and the contact portion (21) are made of silicon.

11. Photonic chip (1) according to Claim 9 or 10, in which the first spacer (24) is made of a silicon nitride, and the second spacer (26) is made of a silicon oxide.

12. Photonic chip (1) according to any one of Claims 9 to 11, in which the waveguide (40) is coplanar and formed contiguously with the contact portion (21).

13. Photonic chip (1) according to any one of Claims 9 to 12, in which the waveguide (40) comprises a broadening region (42) in which its width increases in the direction of the contact portion (21), and the photodiode (20) comprises a coupling region (41) formed by the multiplication portion (22), the charge region (23) and the absorption portion (27), and situated facing the broadening region (42), whose width decreases in the direction of the waveguide (40).
